# EUROPEAN PATENT APPLICATION

(11) **EP 4 415 063 A1**
(43) Date of publication of application: **14.08.2024**
(21) Application number: 22895233.9
(22) Date of filing: 21.09.2022
(51) Int. Cl.: H01L 33/58, H01L 33/50

(54) **SEMICONDUCTOR LIGHT EMITTING DEVICE AND SEMICONDUCTOR LIGHT EMITTING MODULE**

(30) Priority: 22.11.2021 JP 2021189686
(71) Applicant: Stanley Electric Co. Ltd., Tokyo 153-8636 (JP)
(72) Inventor: KONO, Keima, Tokyo 153-8636 (JP); ICHIKAWA, Koji, Tokyo 153-8636 (JP); KAMBARA, Daizo, Tokyo 153-8636 (JP); HORIO, Naochika, Tokyo 153-8636 (JP)
(74) Representative: Pritzlaff, Stefanie Lydia
(86) International application number: PCT/JP2022/035151
(87) International publication number: WO 2023/089947

(57) **Abstract**

A semiconductor light emitting device includes: a wiring substrate on which a p-electrode and an n-electrode are provided on a back surface of a substrate; a light-emitting functional layer including a p-type semiconductor layer connected to the p-electrode, a light emitting layer, and an n-type semiconductor layer connected to the n-electrode, and bonded to an upper surface of the wiring substrate; a light-transmitting optical element having a light shielding film provided on a side surface of a plate-shaped light-transmitting optical body, and which has an annular frame portion that covers a peripheral edge portion of a back surface of the light-transmitting optical body and formed on the peripheral edge portion; and an adhesive layer configured to adhere the light-transmitting optical element to the upper surface of the wiring substrate such that the light-emitting functional layer is inserted into a recessed portion inside the frame portion, in which the recessed portion is filled with the adhesive layer.

## Description

### Technical Field

The present invention relates to a semiconductor light emitting device and a semiconductor light emitting module, and more specifically, to a semiconductor light emitting device having semiconductor light emitting elements such as light emitting diodes (LEDs) and semiconductor light emitting modules.

### Background Art

In recent years, semiconductor light emitting elements such as light emitting diodes (LEDs) are disposed and used in a plurality of devices in order to increase an output or control light distribution.

For example, among vehicle headlights, an adaptive driving beam (ADB) that controls light distribution according to a traveling environment is known. In addition, an LED package for high-output illumination, an LED package for an information communication device in which LEDs are disposed at high density, or the like is known.

However, in a semiconductor light emitting device in which a plurality of semiconductor light emitting elements is arranged side by side, a part of light emitted from a conductive element may generally propagate through a non-conductive element. Such leakage light or crosstalk of light arises as a problem in various application fields in which the plurality of semiconductor light emitting elements is disposed and used.

For example, Patent Literature 1 discloses a semiconductor light emitting device in which side surfaces of a substrate and a light emitting element are covered with a light reflection layer by using an atomic layer deposition method. In addition, Patent Literature 2 discloses a light emitting element including a reflection member that covers a side surface of a semiconductor laminate, in which the reflection member has a first insulator film and a second insulator film including a dielectric multilayer film (distributed Bragg reflector (DBR)).

Patent Literature 3 discloses a light emitting device including a light transmission member, a light emitting element bonded to the light transmission member, and a light guide member extending from a surface of the light emitting element to a surface of the light transmission member.

Patent Literature 4 discloses a light emitting device including a light emitting element, a light transmission member, and a cover member that contains a light reflective material and covers at least a side surface of the light transmission member.

### Citation List

### Patent Literatures

Patent Literature 1: Japanese Patent Application Laid-Open No. 2015-225862
Patent Literature 2: Japanese Patent Application Laid-Open No. 2015-119063
Patent Literature 3: Japanese Patent Application Laid-Open No. 2010-219324
Patent Literature 4: Japanese Patent No. 5526782

### Summary of Invention

### Technical Problem

In the conventional light emitting device described above, a coating film is provided on side surfaces of a wavelength conversion member and a light emitting element, or a light guide member is provided on the side surfaces of the wavelength conversion member and the light emitting element. In such a light emitting device, the coating film on the side surface of the light emitting element or the coating film on a side surface of a bonding portion between the light emitting element and the wavelength conversion member may be peeled off or cracked due to heating during mounting of the light emitting device, thermal history under a usage environment, or the like.

The present invention has been made in view of the above-described point, and an object of the present invention is to provide a light emitting device having high light shielding characteristics of emitted light from a light emitting element and emitted light from a wavelength conversion member and having excellent reliability without providing a separate cover member on a side surface of the light emitting element.

Another object of the present invention is to provide a light emitting module in which a plurality of light emitting devices can be mounted close to each other and in contact with each other, light shielding between the light emitting devices is excellent, crosstalk is suppressed, and reliability is excellent.

### Solution to Problem

A semiconductor light emitting device according to one embodiment of the present invention includes: a wiring substrate on which a p-electrode and an n-electrode are provided on a back surface of a substrate; a light-emitting functional layer including a p-type semiconductor layer connected to the p-electrode, a light emitting layer, and an n-type semiconductor layer connected to the n-electrode, and bonded to an upper surface of the wiring substrate; a light-transmitting optical element having a light shielding film which is provided on a side surface of a plate-shaped light-transmitting optical body, and which has an annular frame portion that covers a peripheral edge portion of a back surface of the light-transmitting optical body and formed on the peripheral edge portion; and an adhesive layer configured to adhere the light-transmitting optical element to the upper surface of the wiring substrate such that the light-emitting functional layer is inserted into a recessed portion inside the frame portion, in which the recessed portion is filled with the adhesive layer.

A semiconductor light emitting module according to another embodiment of the present invention includes:
a plurality of the semiconductor light emitting devices,
in which the plurality of semiconductor light emitting devices is provided such that side surfaces of the light-transmitting optical element are disposed adjacent to each other.

### Brief Description of Drawings

FIG. 1A is a cross-sectional view schematically illustrating a cross section of a semiconductor light emitting device 10 according to a first embodiment of the present invention.
FIG. 1B is a cross-sectional view illustrating a cross section taken along a line A-A of FIG. 1A.
FIG. 1C is an exploded cross-sectional view illustrating a configuration of the semiconductor light emitting device 10, which corresponds to FIG. 1B.
FIG. 2A is a side view illustrating one side surface of the semiconductor light emitting device 10.
FIG. 2B is a plan view illustrating a bottom surface of the semiconductor light emitting device 10.
FIG. 3A is an SEM image showing a cross section of an example of a light shielding film 55.
FIG. 3B is an SEM image showing an upper end portion and a rim portion 55R of the light shielding film 55 in an enlarged manner.
FIG. 3C is an SEM image showing a cross section of the light shielding film 55 according to another example.
FIG. 4A is a graph showing a film thickness of each layer of a dielectric multilayer film of the light shielding film 55.
FIG. 4B is a graph showing a wavelength dependence of a reflectance of the light shielding film 55 having the dielectric multilayer film.
FIG. 5A is a cross-sectional view schematically illustrating a cross section of an example of an LED 11 according to the present embodiment.
FIG. 5B is a cross-sectional view illustrating separately a semiconductor light emitting element portion and a supporting substrate portion of the LED 11, which corresponds to FIG. 5A.
FIG. 5C is a circuit diagram illustrating a connection between electrodes of a light-emitting functional layer 20 and a protective element 17 and an anode 16A and a cathode 16B.
FIG. 6A is a plan view schematically illustrating an upper surface of a wiring substrate 12, that is, a surface on a bonding side with the light-emitting functional layer 20.
FIG. 6B is a plan view schematically illustrating a back surface of the wiring substrate 12, that is, a surface with which the LED 11 is mounted on a circuit substrate such as a PCB substrate.
FIG. 7A is a plan view schematically illustrating an upper surface of the light-emitting functional layer 20.
FIG. 7B is a plan view schematically illustrating a back surface (bonding surface with wiring substrate 12) of the light-emitting functional layer 20.
FIG. 8 is a cross-sectional view schematically illustrating a cross section of an LED 11A of another example in the present embodiment.
FIG. 9A is a top view illustrating a case in which two semiconductor light emitting devices 10 are disposed such that side surfaces thereof are in contact with each other.
FIG. 9B is a cross-sectional view illustrating a cross section when two semiconductor light emitting devices 10 having the same size are disposed in contact with each other.
FIG. 9C is a cross-sectional view illustrating another example of the arrangement of two semiconductor light emitting devices 10.
FIG. 10A is a top view illustrating a case in which two semiconductor light emitting devices 10 are disposed with side surfaces thereof separated from each other.
FIG. 10B is a cross-sectional view illustrating a case in which two semiconductor light emitting devices 10, in which a width WC of a wavelength conversion element 50 and a width WE of the wiring substrate 12 satisfy WE < WC, are disposed.
FIG. 10C is a cross-sectional view illustrating a case in which two semiconductor light emitting devices 10, in which the width WC of the wavelength conversion element 50 and the width WE of the wiring substrate 12 satisfy WE = WC, are disposed.
FIG. 10D is a cross-sectional view illustrating a case in which two semiconductor light emitting devices 10, in which the width WC of the wavelength conversion element 50 and the width WE of the wiring substrate 12 satisfy WE > WC, are disposed.
FIG. 11 is a top view (upper part) and a cross-sectional view (lower part) illustrating a semiconductor light emitting module 60 according to a second embodiment of the present invention.
FIG. 12 is a plan view schematically illustrating wirings of an upper wiring layer 61A and a buried wiring layer 61B of a module substrate 61.
FIG. 13 is a top view illustrating a semiconductor light emitting module 70 according to a third embodiment of the present invention.
FIG. 14 is a cross-sectional view schematically illustrating a cross section taken along a line A-A illustrated in FIG. 13.

### Description of Embodiments

While the present invention is described below in terms of the presently preferred embodiments, appropriate modifications or combinations thereof may be applied. In addition, in the following description and the appended drawings, parts which are substantially identical or equivalent have been assigned identical reference symbols in the description.

### [First Embodiment]

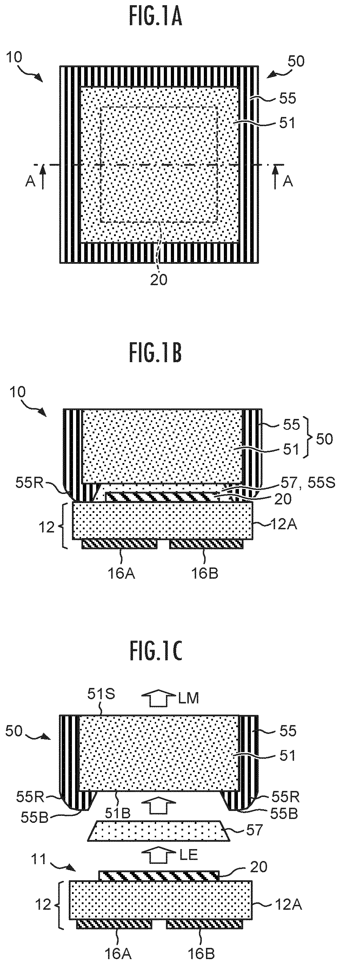

FIG. 1A is a top view schematically illustrating a cross section of a semiconductor light emitting device 10 according to a first embodiment of the present invention. FIG. 1B is a cross-sectional view illustrating a cross section taken along the line A-A of FIG. 1A. In addition, FIG. 1C is an exploded cross-sectional view illustrating a configuration of the semiconductor light emitting device 10, which corresponds to FIG. 1B.

As illustrated in FIGS. 1A, 1B, and 1C, the semiconductor light emitting device 10 includes an LED (light emitting diode) 11, which is a light emitting element, and a wavelength conversion element 50, which is a light-transmitting optical element. The wavelength conversion element 50 is adhered to an LED 11 by a light-transmitting adhesive layer 57.

As illustrated in FIG. 1C, the LED 11 includes a wiring substrate (submount) 12 and a light-emitting functional layer 20. The wiring substrate 12 includes a support substrate 12A, a light-emitting functional layer 20 formed on the support substrate 12A, and an anode 16A and a cathode 16B. Emitted light LE is emitted from the LED 11. The support substrate 12A is, for example, silicon (Si), is opaque to the emitted light from the LED 11, and shields the emitted light.

The light-emitting functional layer 20 is an LED semiconductor layer, and has a p-type semiconductor layer, an n-type semiconductor layer, and a light emitting layer provided between the p-type semiconductor layer and the n-type semiconductor layer. The light-emitting functional layer 20 may include a p-electrode and an n-electrode. For example, a light reflective electrode may be provided on a bottom surface side of the light-emitting functional layer 20, or a light reflection layer may be provided. Alternatively, the light-emitting functional layer 20 may be bonded to the support substrate 12A by a reflective bonding member. In addition, the light-emitting functional layer 20 is electrically connected to the anode 16A and the cathode 16B of the support substrate 12A.

The wavelength conversion element 50 includes a plate-shaped wavelength conversion body 51 and a light shielding film 55 provided on a side surface of the wavelength conversion body 51. In the present embodiment, the light shielding film 55 is provided over the entire side surface of the wavelength conversion body 51. However, the light shielding film 55 may be provided on at least a part of the side surface of the wavelength conversion body 51, that is, a side surface portion to be shielded.

In the following description, the wavelength conversion element 50 has been described as an example of the light-transmitting optical element provided on the LED 11, but the present invention is not limited thereto. The light-transmitting optical element 50 including a light-transmitting optical body 51, instead of the wavelength conversion body 51, and a light shielding film 55 provided on a side surface of the light-transmitting optical body 51 can be applied.

Moreover, in the present embodiment, a case in which the wavelength conversion element 50 has a rectangular column shape has been described by way of example, but the shape of the wavelength conversion element 50 is not limited thereto. For example, the wavelength conversion element 50 may have a shape such as a polygonal shape or a cylindrical shape (including an elliptical cylindrical shape), or any other shape.

Moreover, in the present embodiment, a case in which the light-transmitting adhesive layer 57 is filled between the LED 11 and the light-transmitting optical element 50 has been described by way of example, but the present invention is not limited thereto. For example, the light-transmitting optical element 50 may be adhered only to the periphery of the wiring substrate 12 of the LED 11.

As illustrated in FIG. 1C, the emitted light LE emitted from the light-emitting functional layer 20 of the LED 11 is transmitted through the adhesive layer 57 and is incident on the wavelength conversion body 51 from a back surface 51B of the wavelength conversion body 51 (that is, a surface close to the light-emitting functional layer 20).

The emitted light LE of the LED 11 is, for example, blue light. A part of the emitted light LE of the LED 11 is wavelength-converted into, for example, yellow light when passing through the wavelength conversion body 51. Then, the wavelength conversion body 51 emits white light, which is mixed color light of the yellow light and the blue light transmitted through the wavelength conversion body 51, from an upper surface 51S of the wavelength conversion body 51 (emitted light LM).

The emitted light LE of the LED 11 is not limited to blue light, and may be light in a visible light range, such as red light and green light, light outside the visible light range, such as ultraviolet light and infrared light, or the like.

The light shielding film 55 is formed to cover a peripheral edge portion of the back surface 51B of the wavelength conversion body 51, and has a frame portion (hereinafter, referred to as a rim portion) 55R that protrudes from the back surface 51B. That is, the rim portion 55R is formed on the peripheral edge portion of the back surface 51B of the wavelength conversion body 51 as a rectangular annular frame.

As illustrated in FIG. 1B, a bottom portion 55B of the annular rim portion 55R of the light shielding film 55 is adhered by the adhesive layer 57 so as to be in contact with an upper surface of the wiring substrate 12 of the LED 11. That is, the light-emitting functional layer 20 is inserted into a recessed portion 55S formed inside the rim portion 55R, and the recessed portion 55S is filled with the adhesive layer 57.

The rim portion 55R may be not in contact with the upper surface of the wiring substrate 12, and a gap may be provided between the bottom portion 55B of the rim portion 55R and the upper surface of the wiring substrate 12. Even in this case, the light-emitting functional layer 20 is buried in the adhesive layer 57. It is preferable that at least a part of the bottom portion 55B of the rim portion 55R is in contact with the upper surface of the wiring substrate 12. In addition, from the viewpoint of light shielding properties, it is most preferable that the entire bottom portion 55B of the rim portion 55R is in contact with the upper surface of the wiring substrate 12.

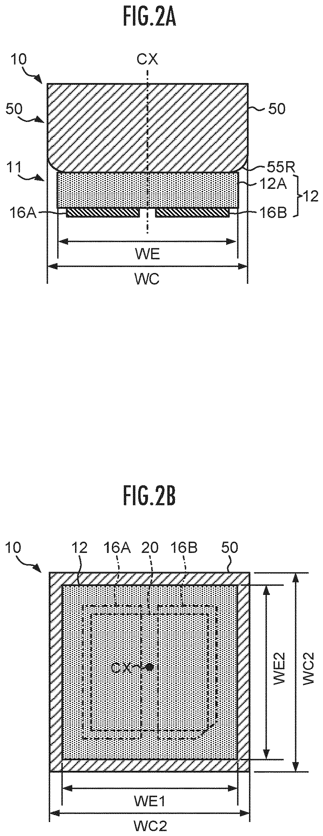

FIG. 2A is a side view illustrating one side surface of the semiconductor light emitting device 10. The wavelength conversion element 50 is placed on the wiring substrate 12. In addition, a central axis CX of the wavelength conversion element 50 is illustrated.

An outer dimension of the semiconductor light emitting device 10 in a horizontal direction is determined by a width WC of the wavelength conversion element 50 and a width WE of the wiring substrate 12. As illustrated in FIG. 2A, the width WC of the wavelength conversion element 50 is larger than the width WE of the wiring substrate 12, and a side surface of the wavelength conversion element 50 protrudes from the side surface of the LED 11, that is, the side surface of the wiring substrate 12. FIG. 2A illustrates a case in which the entire bottom portion 55B of the annular rim portion 55R of the light shielding film 55 is formed in contact with the upper surface of the wiring substrate 12 of the LED 11.

FIG. 2B is a plan view illustrating a bottom surface of the semiconductor light emitting device 10. The anode 16A and the cathode 16B disposed on the bottom surface of the semiconductor light emitting device 10 are illustrated by a one-dot chain line.

On one side surface of the semiconductor light emitting device 10, a width WC1 of the wavelength conversion element 50 is larger than a width WE1 of the wiring substrate 12, and the side surface of the wavelength conversion element 50 protrudes from the side surface of the wiring substrate 12. Similarly, on the other side surface perpendicular to the one side surface of the semiconductor light emitting device 10, a width WC2 of the wavelength conversion element 50 is larger than a width WE2 of the wiring substrate 12, and the side surface of the wavelength conversion element 50 protrudes from the side surface of the wiring substrate 12. In the present specification, unless otherwise distinguished, the widths of the wavelength conversion element 50 are collectively referred to as the width WC and the widths of the wiring substrate 12 are collectively referred to as the width WE.

Therefore, the plurality of semiconductor light emitting devices 10 can be disposed such that the wavelength conversion elements 50 are in contact with each other. In particular, when the semiconductor light emitting device 10 has a rectangular column shape, the plurality of semiconductor light emitting devices 10 can be arranged in a matrix such that four side surfaces of the semiconductor light emitting device 10 are in contact with each other.

As described above, the shape of the wavelength conversion element 50 is not limited to the rectangular column shape, and the wavelength conversion element 50 can have a shape of a polygonal shape (including a triangular column shape, a hexagonal column shape, and the like), a cylindrical shape (including an elliptical cylindrical shape), or any other shape. Even in such a case, the plurality of semiconductor light emitting devices 10 can be disposed such that the wavelength conversion elements 50 are in contact with each other.

At least a part of the side surface of the wavelength conversion element 50 may protrude from the side surface of the wiring substrate 12, but it is most preferable that the entire side surface of the wavelength conversion element 50 protrudes from the side surface of the wiring substrate 12.

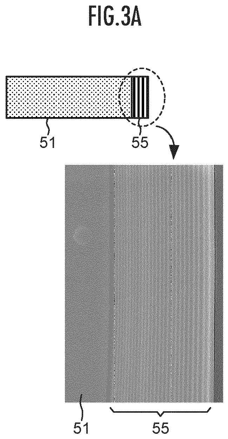

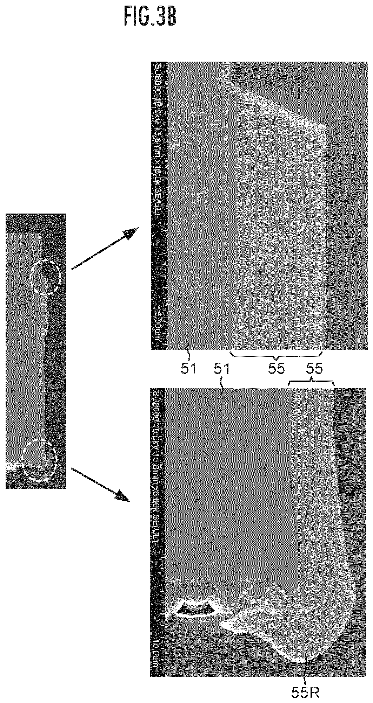

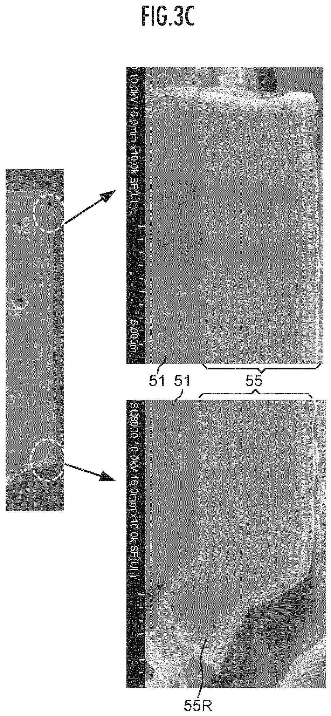

FIG. 3A is a scanning electron microscope (SEM) image showing a cross section of an example of the light shielding film 55. FIG. 3B is an SEM image showing an upper end portion and a rim portion 55R of the light shielding film 55 in an enlarged manner. In addition, FIG. 3C is an SEM image showing a cross section of the light shielding film 55 according to another example.

In this case, the light shielding film 55 was formed of a dielectric multilayer film in which an Al₂O₃ film and a TiO₂ film were alternately laminated. The light shielding film 55 was formed by an atomic layer epitaxy (ALE) method using a gas source molecular beam epitaxy (MBE) device. In addition, the light shielding film 55 can also be formed by an atomic layer deposition (ALD) method.

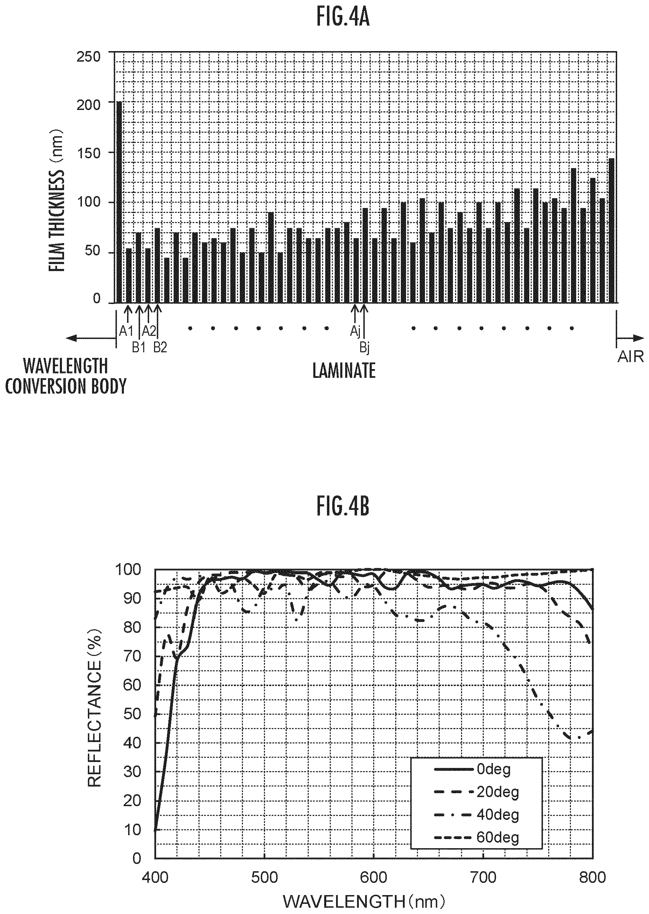

FIG. 4A is a graph showing a film thickness of each layer of the dielectric multilayer film of the light shielding film 55. A thick layer (200 nm) was formed as an underlaying layer, and a dielectric multilayer film functioning as a reflective film was formed on the thick layer. The dielectric multilayer film was formed by alternately laminating two dielectric films having different refractive indices with each other, that is, an Al₂O₃ film (Aj: j = 1, 2, ...) and a TiO₂ film (Bj: j = 1, 2, ...).

The film thickness of each of the Al₂O₃ film and the TiO₂ film was changed such that the angle dependence of the light shielding characteristics in the wavelength range of light incident on the light shielding film 55 was reduced. That is, a multilayer film including an Al₂O₃ film and a TiO₂ film, in which the film thickness was modulated with respect to the film thickness corresponding to λ/4 (λ: wavelength in a medium), was adopted. The total thickness of the light shielding film 55 was 4.7 µm.

FIG. 4B illustrates a result of calculation of the wavelength dependence of the reflectance of the light shielding film 55 having the dielectric multilayer film described above, using the light incidence angle as a parameter. It is understood that low angle dependence of the incidence angle and a high reflectance are obtained in the visible light region.

That is, as described above, the film thickness of each of two films constituting the dielectric multilayer film is changed to deteriorate the wavelength dependence and the angle dependence, so that the light shielding film 55 having a high light shielding performance can be obtained, and even when the wavelength conversion elements 50 are disposed in contact with each other, an inconvenience such as pseudo-emission of light by the adjacent semiconductor light emitting devices 10 can be prevented.

The light shielding film 55 may be formed using a dielectric multilayer film in which the Al₂O₃ film and the TiO₂ film, each having a film thickness corresponding to λ/4, are alternately laminated.

Referring to FIG. 3A, it can be seen that the light shielding film 55 having a flat and uniform layer structure is firmly attached to and formed on a flat side surface of the wavelength conversion body 51. In addition, as illustrated in FIG. 3B, it was confirmed that the light shielding film 55 also had a flat and uniform layer structure at the upper end portion of the light shielding film 55. In addition, it was confirmed that the light shielding film 55 was formed to ride on the peripheral edge portion of the bottom surface of the wavelength conversion body 51, and that the rim portion 55R including a multilayer film was formed on a lower end portion of the light shielding film 55.

FIG. 3C is an SEM image showing a cross section of the light shielding film 55 according to another example. As in FIG. 3B, FIG. 3C illustrates an SEM image in which the upper end portion of the light shielding film 55 and the rim portion 55R are enlarged. In the light shielding film 55 of the other example, the side surface of the wavelength conversion body 51 has a wavy unevenness, and the flatness of the side surface is lower than that of the wavelength conversion body 51 illustrated in FIG. 3B. However, it can be seen that the light shielding film 55 is firmly attached to and formed on the side surface of the wavelength conversion body 51. In addition, the light shielding film 55 sufficiently functions as a light shielding film even in a case where the layer structure of the light shielding film 55 has some ripples. Further, it was confirmed that the rim portion 55R including a multilayer film was formed on the lower end portion of the light shielding film 55.

With such a configuration, among the light emitted from the light-emitting functional layer 20 of the LED 11, the light emitted in a lateral direction (horizontal direction) of the light-emitting functional layer 20 is shielded by the rim portion 55R, and the emission of the light to the outside is prevented. In addition, the light guided inside the wavelength conversion body 51 is also shielded by the light shielding film 55. Therefore, in the semiconductor light emitting device 10, the light is emitted only from the upper surface 51S of the wavelength conversion body 51 (emitted light LM).

Moreover, the light-emitting functional layer 20 is protected by the wiring substrate 12 and the wavelength conversion element 50. In addition, the light-emitting functional layer 20 is hermetically sealed with the adhesive layer 57.

The light shielding film 55 can be formed of, for example, a dielectric multilayer film or a light-shielding ceramic film. As the dielectric multilayer film used in the light shielding film 55, for example, a multilayer film including two or more of Al₂O₃, TiO₂, SiO₂, Ta₂O₅, or Nb₂O₅ can be used, but the present invention is not limited thereto, and a light-shielding or reflective multilayer film in which various films are alternately laminated can be used.

Alternatively, in a case in which a ceramic film is used as the light shielding film 55, for example, a film formed of alumina, zirconia, aluminum nitride, or silicon nitride can be used.

Moreover, as a base material of the wavelength conversion body 51, alumina, glass, aluminous garnet, or the like can be used, and as a phosphor, YAG:Ce, GYAG:Ce, LuAG:Ce, α-sialon, β-sialon, CASN, SCASN, or the like can be used.

As described above, in the semiconductor light emitting device 10, the wavelength conversion element 50 having a size slightly larger than a size of the light-emitting functional layer 20 is adhered to the LED 11. In addition, an electrode to which power is supplied to the LED 11 is provided on an upper surface and/or a lower surface of the support substrate 12A. Therefore, it is possible to realize the semiconductor light emitting device 10 having a size slightly larger than that of the wavelength conversion element 50 and having high light shielding properties in which the emission of light to the side is prevented.

### [Structure of LED 11]

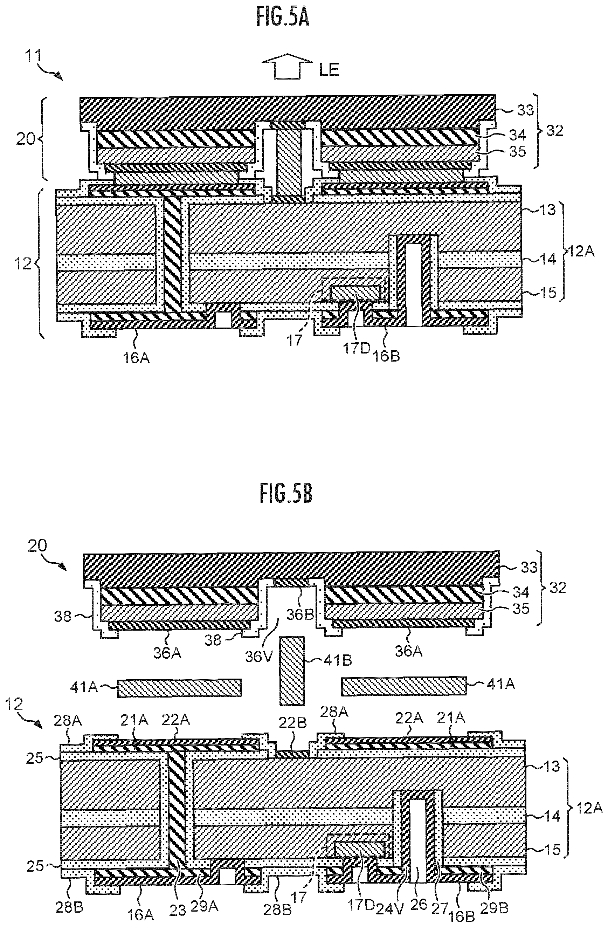

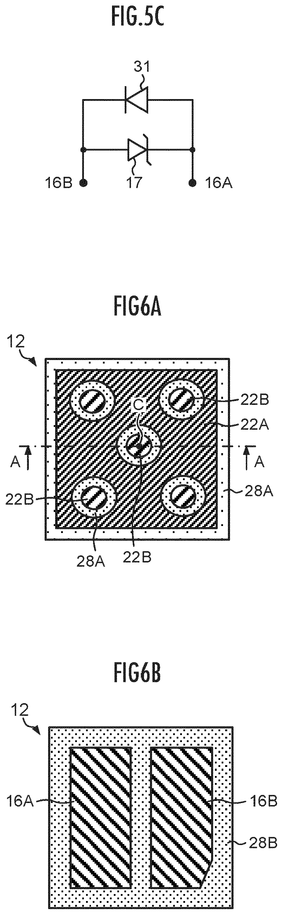

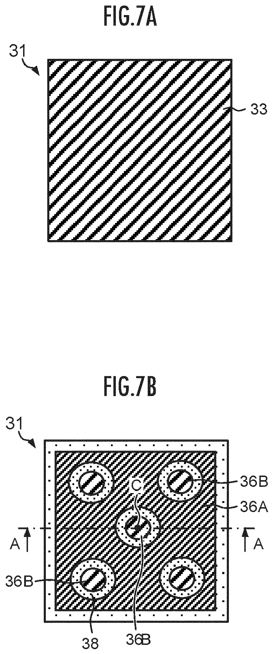

FIG. 5A is a cross-sectional view schematically illustrating a cross section of an example of the LED 11 according to the present embodiment. FIG. 5B is a cross-sectional view illustrating separately a semiconductor light emitting element portion and a supporting substrate portion of the LED 11, which corresponds to FIG. 5A. FIGS. 5A and 5B are cross-sectional views taken along the line A-A illustrated in FIGS. 6A and 7B.

The LED 11 includes the wiring substrate 12 and the light-emitting functional layer 20 bonded onto the wiring substrate 12. The wiring substrate 12 is formed of a first substrate semiconductor layer 13, a second substrate semiconductor layer 15, and an interlayer insulating film 14 provided between the first substrate semiconductor layer 13 and the second substrate semiconductor layer 15.

Moreover, a first mounting electrode (anode) 16A and a second mounting electrode (cathode) 16B, which are electrically connected to the light-emitting functional layer 20 to drive the light-emitting functional layer 20, are provided on the back surface of the wiring substrate 12.

Further, a protective element 17 is provided on the second substrate semiconductor layer 15 of the support substrate 12A. The protective element 17 is electrically connected to the light-emitting functional layer 20 and functions as a protective circuit of the light-emitting functional layer 20.

The light-emitting functional layer 20 has an LED semiconductor layer 32 which is a semiconductor light emitting laminate including an n-type semiconductor layer 33 serving as a second semiconductor layer, a p-type semiconductor layer 35 serving as a first semiconductor layer, and a light emitting layer 34 provided between the n-type semiconductor layer 33 and the p-type semiconductor layer 35. In addition, the light-emitting functional layer 20 includes electrodes 36A and 36B connected to the n-type semiconductor layer 33 and the p-type semiconductor layer 35.

In the present embodiment, the p-type semiconductor layer 35 (first conductive semiconductor layer), which is an outermost growth layer, is used as a lower surface side to bond the light-emitting functional layer 20 to the wiring substrate 12, and the n-type semiconductor layer 33 (second conductive semiconductor layer) is used as a surface layer of the LED 11. The light emitted from the light-emitting functional layer 20 is radiated from the n-type semiconductor layer 33 to an outside of the LED 11 (radiated light LE).

In the present embodiment, a case where the first conductive type is p-type and the second conductive type is n-type will be described, but the first conductive type may be n-type and the second conductive type may be p-type.

FIG. 5B is a schematic cross-sectional view illustrating separately the wiring substrate 12 and the light-emitting functional layer 20 for ease of description and understanding. Hereinafter, the wiring substrate 12 and the light-emitting functional layer 20 will be described in detail with reference to FIG. 5B.

### (Wiring Substrate 12)

The wiring substrate 12 includes a substrate in which an interlayer insulating film is interposed between semiconductor layers, for example, the support substrate 12A which is a silicon on insulator (SOI) substrate. The first substrate semiconductor layer 13 and the second substrate semiconductor layer 15 are n-type Si (silicon) layers doped with, for example, P (phosphorus) or As (arsenic), and the interlayer insulating film 14 is an SiO₂ film. Hereinafter, the first substrate semiconductor layer 13 and the second substrate semiconductor layer 15 will be referred to as an upper Si layer 13 and a lower Si layer 15, respectively.

The wiring substrate 12 is not limited to the silicon on insulator (SOI) substrate. In the present specification, a substrate having a structure in which an interlayer insulating film is interposed between semiconductor layers such as Ge (germanium) is also referred to as a semiconductor on insulator (SOI) substrate.

A first wiring electrode 22A and a second wiring electrode 22B are provided on the upper surface of the wiring substrate 12 (a surface on a bonding side with the light-emitting functional layer 20) (hereinafter, referred to as a wiring electrode 22 unless otherwise distinguished).

In the present embodiment, the first wiring electrode 22A is a p-wiring electrode connected to the first element electrode (p-electrode) of the light-emitting functional layer 20, and the second wiring electrode 22B is an n-wiring electrode connected to the second element electrode (n-electrode) of the light-emitting functional layer 20.

The first wiring electrode (p-wiring electrode) 22A and the second wiring electrode (n-wiring electrode) 22B are protected by a protective film 28A which is an insulating film (for example, a SiO₂ film). The first wiring electrode 22A is provided via an insulating film 25 on the upper Si layer 13, and is electrically insulated from the upper Si layer 13. The second wiring electrode 22B is provided on the upper Si layer 13 and is in ohmic contact with the upper Si layer 13.

Further, on the back surface of the wiring substrate 12, the first mounting electrode 16A and the second mounting electrode 16B (hereinafter, collectively referred to as a mounting electrode 16 unless otherwise distinguished) are provided. The first mounting electrode 16A and the second mounting electrode 16B are connected to wiring on a circuit substrate such as a PCB substrate.

In the present embodiment, the first mounting electrode 16A is an anode, and the second mounting electrode 16B is a cathode. The anode 16A and the cathode 16B are protected by a protective film 28B which is an insulating film (for example, a SiO₂ film).

The anode 16A is connected to the first wiring electrode 22A via a metal via 23 that reaches from the back surface of the support substrate 12A (the back surface of the lower Si layer 15) to the upper surface (the front surface of the upper Si layer 13). Further, the first wiring electrode 22A, the metal via 23, and the anode 16A are insulated from the support substrate 12A by the insulating film 25.

It is desirable that a plurality of metal vias 23 are provided from the viewpoint of preventing conduction failure between the first wiring electrode 22A and the anode 16A and improving heat radiation properties of heat generated by the light-emitting functional layer 20.

The support substrate 12A is provided with a via (via hole) 26 that reaches from the back surface of the support substrate 12A to the front surface of the upper Si layer 13 or the inside thereof. The cathode 16B is electrically connected to the upper Si layer 13 via the via 26.

More specifically, an insulating film 27 is provided on the inner wall of the via 26. The cathode 16B has a via electrode portion 24V that is formed on the insulating film 27 and reaches the upper Si layer 13 from the back surface of the lower Si layer 15. Further, the cathode 16B is insulated from the lower Si layer 15.

The via electrode portion 24V of the cathode 16B is connected in ohmic contact with the upper Si layer 13 exposed from the via 26. Therefore, the cathode 16B is electrically connected to the second wiring electrode 22B via the upper Si layer 13.

It is desirable that the plurality of vias 26 including the via electrode portion 24V are provided from the viewpoint of preventing conduction failure between the second wiring electrode 22B and the upper Si layer 13 and improving heat radiation properties of heat generated by the light-emitting functional layer 20.

Further, the protective element 17 is provided on the lower Si layer 15 of the support substrate 12A. More specifically, the lower Si layer 15 is formed with an impurity diffusion region 17D (p-Si region) in which impurities such as B (boron) or Al (aluminum) are diffused and the protective element 17 (broken part in the drawing) which is a Zener diode (ZD) is formed by pn bonding of the impurity diffusion region 17D and the lower Si layer 15 in contact with the impurity diffusion region 17D.

The impurity diffusion region 17D (p-Si region), which is one end of the protective element 17, is connected to the cathode 16B. The other end of the protective element 17 is connected to the lower Si layer 15 and electrically connected to the anode 16A via the lower Si layer 15 (n-Si layer).

More specifically, as illustrated in FIG. 5C, a positive electrode (anode) and a negative electrode (cathode) of the protective element 17 are connected to the cathode 16B and the anode 16A of the light-emitting functional layer 20, respectively, and are formed to be connected parallel to the light-emitting functional layer 20.

The first wiring electrode 22A is made of, for example, Ni (nickel)/Au (gold), and the second wiring electrode 22B is made of, for example, Ti (titanium) or Ni/Au. In addition, the anode 16A and the cathode 16B are formed of, for example, Ni/Au. In these electrodes, Au is the front surface layer.

### (Light-Emitting Functional Layer 20)

In the present embodiment, a so-called thin-film LED is used as the LED semiconductor layer 32 of the light-emitting functional layer 20. More specifically, the LED semiconductor layer 32 has a configuration in which a semiconductor laminate (thin-film LED) having an LED structure epitaxially grown on a growth substrate is removed from the growth substrate.

The LED semiconductor layer 32 is not limited to a thin-film LED, and a semiconductor light emitting laminate in which a p-electrode and an n-electrode are provided on one surface side can be used.

The LED semiconductor layer 32 includes the n-type semiconductor layer (second semiconductor layer) 33, the light emitting layer 34, and the p-type semiconductor layer (first semiconductor layer) 35. Each of the n-type semiconductor layer 33 and the p-type semiconductor layer 35 is composed of at least one semiconductor layer, and may have various semiconductor layers such as a barrier layer, a current diffusion layer, and a contact layer according to a design such as improved characteristics.

The LED semiconductor layer 32 is, for example, a blue light emitting semiconductor layer formed of a GaN-based semiconductor layer, but is not limited thereto. The light emitting layer 34 has, for example, a single quantum well (SQW) or multiple quantum well (MQW) structure.

The LED semiconductor layer 32 is provided with a p-electrode (first element electrode) 36A and an n-electrode (second element electrode) 36B. The p-electrode 36A is formed on the front surface of the p-type semiconductor layer 35 and is connected in ohmic contact with the p-type semiconductor layer 35.

The LED semiconductor layer 32 is formed with via 36V reaching the n-type semiconductor layer 33 from the front surface of the p-type semiconductor layer 35, and the n-electrode 36B is provided on the n-type semiconductor layer 33 exposed from the via 36V and is connected in ohmic contact with the n-type semiconductor layer 33.

An element protective film 38 formed of SiO₂ is provided on the side surface, the bottom surface (the surface on the bonding side with the wiring substrate 12), and the inner wall surface of the via 36V of the LED semiconductor layer 32. The element protective film 38 protects the side surface of the LED semiconductor layer 32 and the p-electrode 36A, the n-electrode 36B, and the inner wall surface of the via 36V

The p-electrode 36A is formed of an ITO/Ni/Pt/Ag layer in which indium tin oxide (ITO), nickel (Ni), platinum (Pt), and silver (Ag) reflective films of a translucent conductive film are formed on the p-type semiconductor layer 35 in this order. The p-electrode 36A is preferably provided with a reflective film, but may not be provided with a reflective film.

The n-electrode 36B is formed of a Ti/Au layer in which titanium (Ti) and gold (Au) are formed on the n-type semiconductor layer 33 in this order. Rhodium (Rh), palladium (Pd), or the like can be used instead of Au.

The materials and structures of the p-electrode 36A and the n-electrode 36B are not limited to the above. The materials and structures thereof can be appropriately selected in consideration of characteristics such as extraction efficiency improvement by light reflection, ohmic characteristics, and element reliability (lifespan).

### (Bonding of Wiring Substrate 12 and Light-Emitting Functional Layer 20)

The wiring substrate 12 and the light-emitting functional layer 20 are bonded to each other by a bonding layer 41A and a bonding layer 41B to form the LED 11 illustrated in FIG. 5A.

More specifically, the first wiring electrode (p-wiring electrode) 22A of the wiring substrate 12 is bonded to the p-electrode 36A of the light-emitting functional layer 20 by the bonding layer 41A. The second wiring electrode 22B of the wiring substrate 12 is bonded to the n-electrode 36B of the light-emitting functional layer 20 by the bonding layer 41B.

### (Upper surface and Back surface of Wiring Substrate 12 and Light-Emitting Functional Layer 20)

FIG. 6A is a plan view schematically illustrating the upper surface of the wiring substrate 12, that is, the surface on the bonding side of the light-emitting functional layer 20. FIG. 6B is a plan view schematically illustrating the back surface of the wiring substrate 12, that is, the surface with which the LED 11 is mounted on a circuit substrate such as a PCB substrate.

As illustrated in FIG. 6A, a plurality of circular second wiring electrodes 22B (n-wiring electrodes) is disposed on the wiring substrate 12 (five in the present embodiment). The plurality of second wiring electrodes 22B is insulated from the first wiring electrode (p-wiring electrode) 22A by the protective film 28A which is an insulating film.

The plurality of second wiring electrodes 22B may be formed in a number, position, and size such that current diffusion is good and light emission becomes uniform.

Moreover, the first wiring electrode 22A is disposed over the entire surface of the upper Si layer 13 of the support substrate 12A, except for the regions of the plurality of second wiring electrodes 22B and the protective film 28A.

As illustrated in FIGS. 5B and 6A, the plurality of second wiring electrodes 22B is connected to the cathode 16B on the back surface of the wiring substrate 12, and the first wiring electrode 22A is connected to the anode 16A.

FIG. 7A is a plan view schematically illustrating the upper surface of the light-emitting functional layer 20, that is, the surface on which the radiated light LO is emitted, and the front surface of the n-type semiconductor layer 33. In addition, FIG. 7B is a plan view schematically illustrating a back surface (bonding surface with the wiring substrate 12) of the light-emitting functional layer 20.

### (Electrode Conversion Function of Wiring Substrate 12)

The wiring substrate 12 has a so-called electrode conversion function. Specifically, as illustrated in FIG. 7B, one p-electrode 36A and a plurality of n-electrodes 36B (five in the present embodiment) are provided on the back surface (bonding surface with the wiring substrate 12) of the light-emitting functional layer 20.

It is sufficient that at least one p-electrode 36A and one n-electrode 36B are provided, but it is preferable that a plurality of n-electrodes 36B are provided. The number, size, and disposition of the p-electrodes 36A and the n-electrodes 36B can be appropriately designed according to the current diffusion and the emission brightness.

On the other hand, as illustrated in FIG. 6A, the first wiring electrode 22A and the second wiring electrode 22B, which has the number, size, and arrangement corresponding to the p-electrode 36A and the n-electrode 36B of the light-emitting functional layer 20, are provided on the upper surface (bonding surface with the light-emitting functional layer 20) of the wiring substrate 12.

It is preferable that a plurality of (n, where n is an integer of 2 or more) n-electrodes 36B is provided. In this case, it is preferable that the plurality of n-electrodes 36B provided on the bottom surface of the light-emitting functional layer 20 is disposed so as to be in symmetrical positions. For example, as illustrated in FIG. 7B, it is preferable that the plurality of n-electrodes 36B may be disposed at symmetrical positions with respect to a center point C of the light-emitting functional layer 20 or the center line (for example, the symmetrical line A-A).

Further, in the present embodiment, the case where the n-electrode 36B has a circular shape has been described as an example, but the present embodiment is not limited thereto. The n-electrode 36B may have a shape according to the shape and size of the light-emitting functional layer 20, the number, size, and disposition of the n-electrode 36B, and the like. Further, the plurality of n-electrodes 36B may not have the same shape.

Further, as illustrated in FIG. 7B, it is preferable that the p-electrode 36A of the light-emitting functional layer 20 is formed as an electrode over the entire surface of the p-type semiconductor layer 35, so-called full-surface electrode, except the region where the n-electrode 36B is formed (that is, the region of the n-electrode 36B and the region of the element protective film 38 protecting the edge portion of the n-electrode 36B).

As illustrated in FIG. 6B, each anode 16A and cathode 16B are provided on the back surface of the wiring substrate 12 (that is, the surface with which the LED 11 is mounted on the circuit substrate), and the p-electrodes 36A and the n-electrodes 36B of the light-emitting functional layer 20 are connected to the anode 16A and cathode 16B, respectively.

That is, even when a plurality of p-electrodes 36A and/or n-electrodes 36B are provided in the light-emitting functional layer 20 in order to improve element characteristics such as current diffusion, the anode 16A and the cathode 16B of the wiring substrate 12 can be integrated into each one, and it is possible to facilitate the wiring of the circuit substrate such as a PCB substrate.

### [Another Example of LED 11]

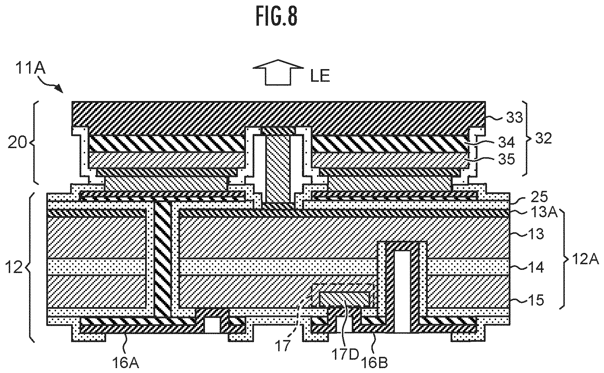

FIG. 8 is a cross-sectional view schematically illustrating a cross section of an LED 11A of another example in the present embodiment. The point at which the LED 11A is different from the LED 11 described above is that a metal electrode layer 13A is provided on the upper Si layer 13.

More specifically, the metal electrode layer 13A is electrically connected to the second wiring electrode 22B (n-wiring electrode). The metal electrode layer 13A functions as a current diffusion layer, and thus even when the current diffusion is insufficient due to resistivity of the upper Si layer 13 (n-Si layer), the current diffusion can be improved. Therefore, in-plane uniformity of light emission and the light emission efficiency can be improved. The metal electrode layer 13A is preferably formed over the entire surface of the upper Si layer 13 except for a region where the second wiring electrode 22B is provided.

### [Size and Arrangement of Wavelength Conversion Element and LED]

### (1) Contact Arrangement

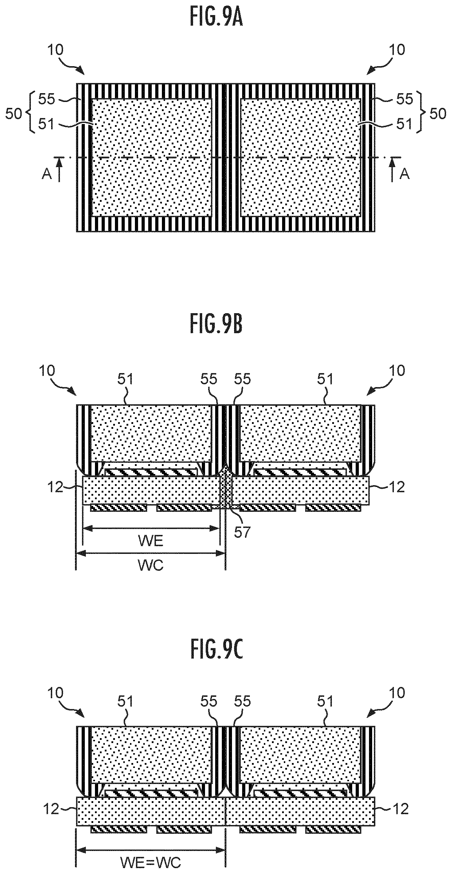

A plurality of the above-described semiconductor light emitting devices 10 can be disposed in contact with each other. FIG. 9A is a top view illustrating a case in which two semiconductor light emitting devices 10 are disposed such that side surfaces thereof are in contact with each other.

FIG. 9B is a cross-sectional view illustrating a cross section (cross section taken along the line A-A of FIG. 9A) when two semiconductor light emitting devices 10 having the same size are disposed in contact with each other. In this case, the width WC of the wavelength conversion element 50 is larger than the width WE of the LED 11 (WE < WC), and the side surface of the wavelength conversion element 50 protrudes from the side surface of the LED 11.

Therefore, two semiconductor light emitting devices 10 can be disposed such that the side surfaces of the wavelength conversion element 50 are in contact with each other. That is, the light from the semiconductor light emitting device 10 to the side is shielded by the light shielding film 55 of the wavelength conversion element 50, so that crosstalk and leakage are also suppressed by the contact arrangement, thereby providing a light module having a high contrast on a light emission surface.

A cover member or a sealing member may be filled between the LEDs 11 of two semiconductor light emitting devices 10 to form an underfill 57. As the sealing member, for example, a light reflective or light absorbent resin (so-called white resin or black resin) used for sealing a light module or the like can be used.

As described above, the plurality of semiconductor light emitting devices 10 can be disposed in contact with each other by using the wavelength conversion element 50 having the side surface protruding from the wiring substrate 12 on at least one side surface.

Moreover, in the semiconductor light emitting device 10 of the present embodiment, the anode 16A and the cathode 16B for driving the LED 11 are provided on the back surface of the wiring substrate 12, so that it is not necessary to provide an electrode for connection with the outside on the upper surface of the wiring substrate 12. Therefore, the semiconductor light emitting device 10 in which the entire side surface of the wavelength conversion element 50 protrudes from the entire side surface of the wiring substrate 12 can be realized.

In the present embodiment, the semiconductor light emitting device 10 has a rectangular column shape, and since the side surface of the wavelength conversion element 50 of the entire four side surfaces protrudes from the side surface of the wiring substrate 12 (see FIGS. 2A and 2B), it is possible to dispose all semiconductor light emitting devices 10 in contact with each other.

FIG. 9C is a cross-sectional view illustrating another example of the arrangement of two semiconductor light emitting devices 10. That is, in two semiconductor light emitting devices 10, even when the width WC of the wavelength conversion element 50 is the same as the width WE of the wiring substrate 12 (WE = WC), the semiconductor light emitting devices 10 can be disposed so as to be in contact with each other. In this case, the side surfaces of the wiring substrate 12 of the semiconductor light emitting device 10 are provided with insulating films such as SiO₂ such that the side surfaces are not short-circuited with each other.

### (2) Separation Arrangement (Adjacent Arrangement)

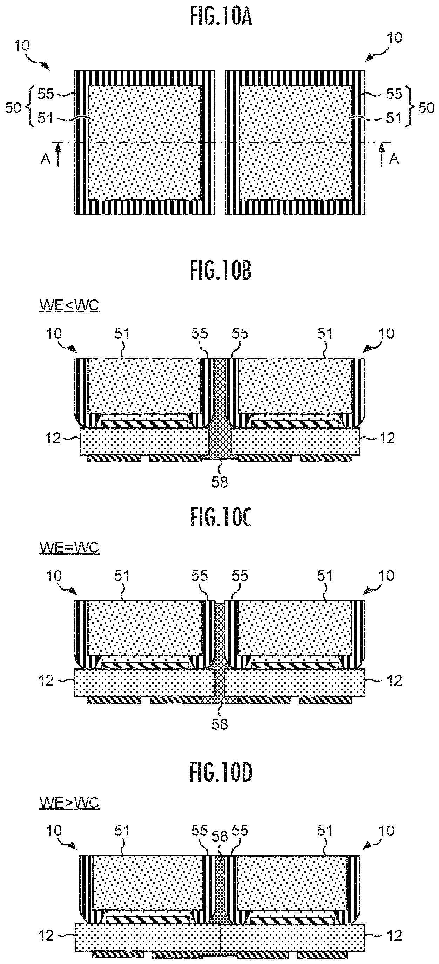

FIG. 10A is a top view illustrating a case in which two semiconductor light emitting devices 10 are disposed with side surfaces thereof separated from each other. FIGS. 10B, 10C, and 10D are cross-sectional views illustrating cases in which two semiconductor light emitting devices 10, which have relationships of WE < WC, WE = WC, and WE > WC with respect to the width WC of the wavelength conversion element 50 and the width WE of the wiring substrate 12, are disposed, respectively.

As described above, even when the plurality of semiconductor light emitting devices 10 are disposed by separating the side surfaces from each other, the light shielding film 55 shields light from each of the semiconductor light emitting devices 10, so that the separation arrangement also suppresses crosstalk or leakage, thereby providing a light module having high contrast on a light emission surface.

A gap between two semiconductor light emitting devices 10 may be filled with a sealing member to form a sidefill 58. Since the light shielding film 55 is provided on the semiconductor light emitting device 10, the sidefill 58 may be transparent, white, or black.

### [Second Embodiment]

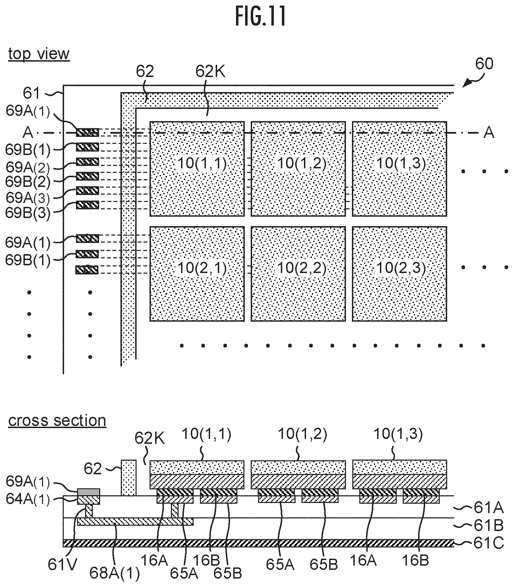

FIG. 11 is a top view (upper part) and a cross-sectional view (lower part) taken along the line A-A of the top view, which illustrate a semiconductor light emitting module 60 according to a second embodiment of the present invention.

The semiconductor light emitting module 60 according to the second embodiment has semiconductor light emitting devices 10 (m, n) arranged in a m × n matrix (m and n are natural numbers). In addition, the semiconductor light emitting module 60 includes a module substrate 61 which is a low temperature co-fired ceramics (LTCC) multilayer ceramic substrate. When each of the semiconductor light emitting devices 10 (m, n) are collectively referred to as the semiconductor light emitting device 10 unless otherwise distinguished.

A frame 62 is provided on the module substrate 61, and the semiconductor light emitting devices 10 (m, n) are mounted inside the frame 62. Although a case in which the respective side surfaces of the semiconductor light emitting devices 10 (m, n) are disposed adjacent to each other with a gap has been illustrated and described, the semiconductor light emitting devices 10 (m, n) may be disposed in contact with each other.

The semiconductor light emitting devices 10 (m, n) may be light emitting devices having the same light emission color or light emitting devices having different light emission colors. In addition, output light intensity of the respective semiconductor light emitting devices 10 (m, n) may be different from each other.

Moreover, since the semiconductor light emitting device 10 (m, n) is shielded by the light shielding film 55, the cover member is not necessarily provided in a space 62K between the semiconductor light emitting devices 10 (m, n). However, when the cover member is provided for the purpose of protection of the semiconductor light emitting devices 10 (m, n) or the appearance of the device, a cover member having light transmittance, white color, black color, or the like can be appropriately selected and used.

The module substrate 61 includes an upper wiring layer (first wiring layer) 61A, a buried wiring layer (second wiring layer) 61B, and a module bonding layer 61C provided on a bottom surface of the substrate. In addition, a first terminal 69A and a second terminal 69B (collectively referred to as a terminal 69 unless otherwise distinguished) electrically connected to the semiconductor light emitting devices 10 (m, n) are provided on the module substrate 61. The first terminal 69A and the second terminal 69B are, for example, an anode and a cathode, respectively.

In FIG. 11, the first terminal 69A and the second terminal 69B (a pair of terminals) in the first column, the second column, ... of each row are denoted as 69A (1) and 69B (1), 69A (2) and 69B (2), ... and the like. Similarly to the terminal wirings 64A and 64B and buried wirings 68A and 68B, which will be described later, the terminal wirings 64A and 64B and buried wirings 68A and 68B are collectively referred to as a terminal wiring 64 and a buried wiring 68 unless otherwise distinguished.

Hereinafter, constituent members of the semiconductor light emitting module 60 will be described in detail. As a base material of the module substrate 61, for example, ceramics such as alumina, zirconia, or aluminum nitride can be used. In addition, as a wiring material, for example, silver (Ag), copper (Cu), or tungsten (W) can be used. As the surface wiring material, for example, nickel/gold (Ni/Au) can be used. When the ceramic is selected as a base material of the module substrate 61, for example, the ceramic can be used under a wide temperature environment from a low temperature of - 45°C to a high temperature of 120°C. If a usage environment is within a range of about room temperature of ±30°C, a glass fiber-reinforced epoxy resin can be used as a base material.

As the module bonding layer 61C, for example, tungsten/nickel/gold (W/Ni/Au) can be used. When the semiconductor light emitting module 60 is adhered to a heat sink or the wiring substrate with an adhesive, it is not necessary to provide the module bonding layer 61C.

For the frame 62, for example, a silicone resin or an epoxy resin can be used. When the frame 62 is white, for example, titanium oxide particles or alumina particles can be contained in the silicone resin, the epoxy resin, or the like, and when the frame 62 is black, for example, black titanium oxide, black alumina, carbon black, or the like can be contained. A thickener and a thixotropic agent may be contained.

As illustrated in the cross-sectional view (lower part) of FIG. 11, the upper wiring layer 61A of the module substrate 61 has the mounting wirings 65A and 65B to which the anode 16A and the cathode 16B of the semiconductor light emitting devices 10 (m, n) are respectively connected while being bonded, and the terminal wirings 64A and 64B to which the first terminal 69A and the second terminal 69B (a pair of terminals) are connected.

Moreover, the module substrate 61 includes a buried wiring layer 61B provided on a lower surface side of the upper wiring layer 61A. The buried wiring layer 61B includes buried wirings 68A and 68B. The mounting wirings 65A and 65B of the upper wiring layer 61A (collectively referred to as mounting wiring 65 unless otherwise distinguished) and the terminal wirings 64A and 64B are connected to the buried wirings 68A and 68B of the buried wiring layer 61B via the via wiring 61V.

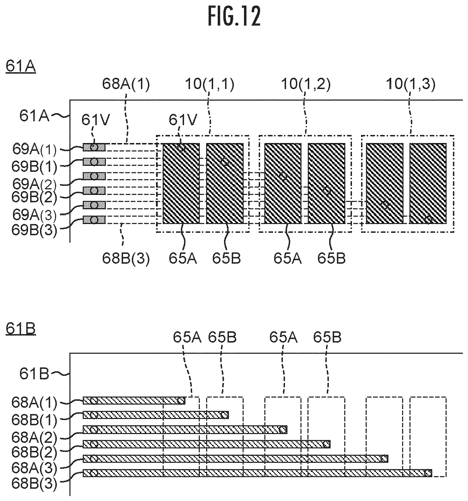

FIG. 12 is a plan view schematically illustrating wirings of the upper wiring layer 61A and the buried wiring layer 61B of the module substrate 61. For ease of description and understanding, the upper wiring layer 61A and the buried wiring layer 61B are illustrated in the upper and lower parts, respectively.

For example, the anode 16A and the cathode 16B of the semiconductor light emitting devices 10 (1, k) in the first row and the k-th column (k = 1, 2, ..., n) are connected to the buried wirings 68A (k) and 68B (k). The buried wirings 68A (k) and 68B (k) are connected to the first terminal 69A (k) and the second terminal 69B (k), respectively, via the via wiring 61V.

That is, a voltage is applied between the first terminal 69A (k) and the second terminal 69B (k) so as to allow the semiconductor light emitting device 10 (1, k) to emit light. The same applies to the semiconductor light emitting devices 10 (j, k) of each row (j = 1, 2, ..., m), and each of the semiconductor light emitting devices 10 can be individually controlled to emit light.

Therefore, a light emission pattern and the brightness of each of the semiconductor light emitting devices 10 can be adjusted by controlling the emission of light for each of the semiconductor light emitting devices 10. In addition, the light emission color can be selected for each semiconductor light emitting device 10, and RGB full color can be displayed.

Furthermore, according to the semiconductor light emitting device 10 of the present embodiment, it is possible to provide a semiconductor light emitting module having excellent light shielding properties, extremely small light leakage and crosstalk even if the semiconductor light emitting devices 10 are disposed so as to be in contact with each other, and high contrast on the light emission surface. In addition, it is possible to provide a semiconductor light emitting module in which the semiconductor light emitting devices are arranged in a compact manner.

Moreover, in the light emitting module according to the present embodiment, since the anode and the cathode of the semiconductor light emitting device 10 on the device back surface are connected while being bonded to the mounting wiring on the module substrate, wire bonding is not required. In addition, as described above, a built-in protective element is provided in the wiring substrate 12 according to the present embodiment. The wire bonding is also not required for the protective element. Therefore, the manufacturing process is simple, and the reliability and the lifespan of the light emitting module are also excellent.

Furthermore, the plurality of semiconductor light emitting devices 10 can be disposed in contact with or close to other semiconductor light emitting devices 10 over the entire periphery of the semiconductor light emitting device 10. Therefore, even in an arrangement of three or more columns the semiconductor light emitting device 10 can be in contact with or close to each other.

In the present specification, the close arrangement refers to a case in which the semiconductor light emitting devices 10 are disposed to be spaced apart from each other with a narrow gap (200 µm or less).

### [Third Embodiment]

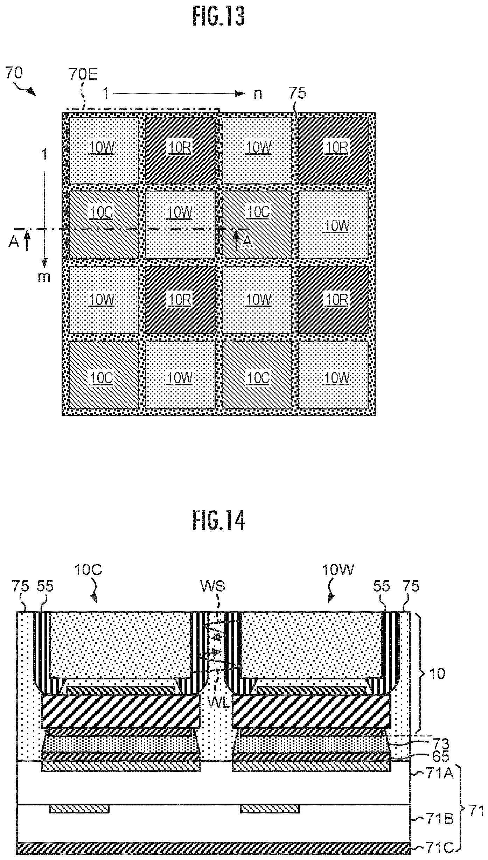

FIG. 13 is a top view illustrating a semiconductor light emitting module 70 according to a third embodiment of the present invention. The semiconductor light emitting module 70 has semiconductor light emitting devices 10 (m, n) in a matrix array. Specifically, the semiconductor light emitting module 70 has a 4 × 4 matrix structure (m = 4, n = 4) in which 16 semiconductor light emitting devices 10 having different light emission colors are arranged in four rows and four columns.

More specifically, the semiconductor light emitting module 70 is configured by arranging a unit array 70E, which is formed of four semiconductor light emitting devices 10 in 2 × 2 array, arranged in two rows and two columns. In the unit array 70E, two white (WW) semiconductor light emitting devices 10W are arranged at diagonal positions (= 10 (1, 1), 10 (2, 2)), and a cyan (C) semiconductor light emitting device 10C (= 10 (2, 1)) and a red (R) semiconductor light emitting device 10R (= 10 (1, 2)) are arranged at other diagonal positions.

In each of the 16 semiconductor light emitting devices 10, four side surfaces of the wavelength conversion element 50 protrude from the side surface of the wiring substrate 12 (WE ≤ WC, see FIG. 2B). Each of the 16 semiconductor light emitting devices 10 is disposed in a narrow gap (for example, a narrow gap of 20 to 200 µm) from each other.

Each of the semiconductor light emitting devices 10 may be disposed in a narrow gap of 100 µm or less or in a further narrow gap of 50 µm or less. The side surface of each of the wavelength conversion elements 50 of the semiconductor light emitting device 10 may be in contact with the side surface of the other wavelength conversion element 50, and each of the semiconductor light emitting devices 10 may be disposed such that the semiconductor light emitting devices 10 are in contact with each other.

The semiconductor light emitting module 70 is a white light emitting module having high color rendering properties in which the semiconductor light emitting devices 10 of WW (white), C (cyan), and R (red) are arranged. In the white semiconductor light emitting device 10 (W) consisting of blue and yellow, spectral intensity of cyan and red is low. The cyan and the red have a complementary color relationship with each other, in which the cyan color compensates for the spectral loss between blue and green-yellow, and the red color compensates for the spectral loss in the red region. With such a combination, a white light emitting module having high color rendering properties can be obtained. For example, when the white light emitting module is used as a light source of a luminaire for a vehicle, it can be adjusted to white light having a low color temperature and good visibility when fog or the like occurs. In addition, the semiconductor light emitting device 10 disposed in the unit array 70E can be used as a color display module such as RRGB.

FIG. 14 is a cross-sectional view schematically illustrating a cross section taken along the line A-A illustrated in FIG. 13. That is, FIG. 14 illustrates a cross section crossing two semiconductor light emitting devices 10 disposed adjacent to each other, and in this case, a cross section crossing the semiconductor light emitting device 10C and the semiconductor light emitting device 10W disposed adjacent to the semiconductor light emitting device 10C.

The semiconductor light emitting device 10 is mounted on the module substrate 71 via a bonding layer 73. More specifically, the module substrate 71 includes an upper wiring layer 71A, a buried wiring layer 71B, and a module bonding layer 71C provided on a bottom surface of the substrate. The semiconductor light emitting device 10 is mounted while being bonded to the upper wiring layer 71A.

The semiconductor light emitting device 10C and the semiconductor light emitting device 10W are disposed adjacent to each other while being bonded to the mounting wiring 65 of the upper wiring layer 71A. More specifically, the semiconductor light emitting devices 10C and 10W are disposed close to each other with a narrow gap of 200 µm or less. Similarly to the semiconductor light emitting device 10R, the semiconductor light emitting devices 10C, 10W, and 10R are disposed close to each other with a narrow gap.

The semiconductor light emitting device 10 has the above-described configuration, and the light leakage in the horizontal direction is prevented by the light shielding films 55 of the wavelength conversion elements 50 of the semiconductor light emitting devices 10 adjacent to each other, regardless of the long-wavelength light WL and the short-wavelength light WS. In addition, it is possible to prevent light leakage due to the adjacent light emitting device emitting pseudo light when the power is supplied to each system.

Moreover, when the semiconductor light emitting devices 10 are disposed adjacent to or in contact with each other, two light shielding films 55 are disposed between the light-emitting functional layer 20 and the wavelength conversion body 51 of the adjacent semiconductor light emitting devices 10. For example, when the light leakage of one light shielding film is 0.05 (5%), the light leakage is attenuated to 0.0025 (0.25%) by the two light shielding films 55. In addition, by disposing a light-shielding (reflective or absorptive) cover member 75 between the adjacent semiconductor light emitting devices 10, the light leakage can be further reduced.

With the semiconductor light emitting module 70 according to the present embodiment, the same advantages as those of the semiconductor light emitting modules of the second embodiment described above can be obtained. That is, a plurality of semiconductor light emitting devices can be disposed close to and in contact with each other, and three or more rows thereof can be disposed close to and in contact with each other. Furthermore, the light shielding between the light emitting devices is excellent, so that it is possible to prevent light leakage due to the pseudo light emission of the adjacent semiconductor light emitting devices 10.

Furthermore, with the semiconductor light emitting module 70 according to the present embodiment, the plurality of semiconductor light emitting devices having one light emission color and the plurality of semiconductor light emitting devices having a different light emission color can be alternately disposed in a checkered pattern. That is, even in a case where the semiconductor light emitting devices are disposed in this manner, it is possible to provide a semiconductor light emitting module in which light shielding between the light emitting devices is excellent and deviation in light emission color of each semiconductor light emitting device is suppressed. In addition, it is possible to provide a light emitting module having high color rendering properties.

In the semiconductor light emitting module 70, the semiconductor light emitting devices 10 (m, n) are preferably arranged in three rows and three columns or more (3 ≤ m and 3 ≤ n).

Moreover, the semiconductor light emitting module 70 is preferably a module arranged in an RRGB matrix (R: red, G: green, B: blue) or a light emitting module arranged in an RGGB matrix.

Moreover, the semiconductor light emitting module 70 preferably includes at least two sets of the semiconductor light emitting devices 10 among three sets of two colors having complementary color relationships with each other, that is, blue (B) and yellow (Y), red (R) and cyan (C), and green (G) and purple (P).

Moreover, the semiconductor light emitting module 70 preferably includes four-color semiconductor light emitting devices 10 of two-color semiconductor light emitting devices 10 of blue (B) and yellow (Y), and two-color semiconductor light emitting devices 10 having complementary color relationships with the two-color semiconductor light emitting devices 10 of blue (B) and yellow (Y).

As described in detail above, according to the present invention, it is possible to provide a light emitting device having high performance of shielding emitted light from a light emitting element and emitted light from a wavelength conversion member without providing individual cover members on side surfaces of the light emitting element. In addition, it is possible to provide a light emitting module in which a plurality of light emitting devices can be disposed close to each other and in contact with each other, and which has excellent light shielding between the light emitting devices and suppressed crosstalk. Furthermore, it is possible to provide a light emitting module having high color rendering properties.

### Description of Reference Numerals

10, 10(m, n), 10C, 10R, 10W: semiconductor light emitting device
11, 11A: light emitting element
12: wiring substrate
12A: support substrate
13A: metal electrode layer
16A: anode
16B: cathode
17: protective element
20: light-emitting functional layer
32: LED semiconductor layer
33: n-type semiconductor layer
34: light emitting layer
35: p-type semiconductor layer
50: wavelength conversion element
51: wavelength conversion body
55: light shielding film
55R: rim portion
55S: recessed portion
57: adhesive layer
60, 70: semiconductor light emitting module
61, 71: module substrate
61A, 71A: upper wiring layer
61B, 71B: buried wiring layer
61V: via wiring
62: frame
64A, 64B: terminal wiring
65A, 65B: mounting wiring
68A, 68B: buried wiring
69A, 69B: terminal
70E: unit array of semiconductor light emitting device
75: cover member

## Claims

1. A semiconductor light emitting device comprising:
a wiring substrate on which a p-electrode and an n-electrode are provided on a back surface of a substrate;
a light-emitting functional layer including a p-type semiconductor layer connected to the p-electrode, a light emitting layer and an n-type semiconductor layer connected to the n-electrode, and bonded to an upper surface of the wiring substrate;
a light-transmitting optical element having a light shielding film which is provided on a side surface of a plate-shaped light-transmitting optical body, and which has an annular frame portion that covers a peripheral edge portion of a back surface of the light-transmitting optical body and formed on the peripheral edge portion; and
an adhesive layer configured to adhere the light-transmitting optical element to the upper surface of the wiring substrate such that the light-emitting functional layer is inserted into a recessed portion inside the frame portion,
wherein the recessed portion is filled with the adhesive layer.

2. The semiconductor light emitting device according to claim 1,
wherein at least a part of a side surface of the light-transmitting optical element protrudes from a side surface of the wiring substrate.

3. The semiconductor light emitting device according to claim 1 or 2,
wherein at least a part of the frame portion of the light shielding film is in contact with the upper surface of the wiring substrate.

4. The semiconductor light emitting device according to any one of claims 1 to 3,
wherein the light shielding film is provided over the entire side surface of the light-transmitting optical body.

5. The semiconductor light emitting device according to any one of claims 1 to 4,
wherein at least a part of a side surface of the light-transmitting optical element protrudes from a side surface of the wiring substrate.

6. The semiconductor light emitting device according to any one of claims 1 to 4,
wherein the light-transmitting optical element has a rectangular column shape, and all four side surfaces of the light-transmitting optical element protrude from a side surface of the wiring substrate.

7. The semiconductor light emitting device according to any one of claims 1 to 4,
wherein the light-emitting functional layer has a reflective layer on a surface close to the wiring substrate.

8. The semiconductor light emitting device according to any one of claims 1 to 7,
wherein the light-transmitting optical element is a wavelength conversion element.

9. The semiconductor light emitting device according to any one of claims 1 to 8, wherein the wiring substrate is provided with a built-in protective element.

10. The semiconductor light emitting device according to any one of claims 1 to 9,
wherein the light shielding film is a dielectric multilayer film and/or a ceramic film.

11. A semiconductor light emitting module comprising:
a plurality of the semiconductor light emitting devices according to any one of claims 1 to 10,
wherein the plurality of semiconductor light emitting devices is provided such that side surfaces of the light-transmitting optical element are disposed adjacent to each other.

12. A semiconductor light emitting module comprising:
a plurality of the semiconductor light emitting devices according to any one of claims 1 to 10,
wherein the plurality of semiconductor light emitting devices is provided such that side surfaces of the light-transmitting optical element are disposed in contact with each other.

13. The semiconductor light emitting module according to claim 11 or 12,
wherein the plurality of semiconductor light emitting devices includes at least two of the semiconductor light emitting devices having different light emission colors from each other.

14. A semiconductor light emitting module comprising:
a plurality of the semiconductor light emitting devices according to any one of claims 1 to 10,
wherein the semiconductor light emitting devices are arranged in at least a 3 × 3 matrix.

15. A semiconductor light emitting module comprising:
a plurality of the semiconductor light emitting devices according to any one of claims 1 to 10,
wherein the semiconductor light emitting modules are a module arranged in an RRGB matrix (R: red, G: green, B: blue) or a light emitting module arranged in an RGGB matrix.

16. A semiconductor light emitting module comprising:
a plurality of the semiconductor light emitting devices according to any one of claims 1 to 10,
wherein the semiconductor light emitting modules include at least two sets of two-color combinations having complementary color relationships with each other.

17. The semiconductor light emitting module according to claim 16,
wherein the two-color combinations having the complementary color relationships with each other are three sets of blue (B) and yellow (Y), red (R) and cyan (C), and green (G) and purple (P).
